# EUROPEAN PATENT SPECIFICATION

(11) **EP 3 232 484 B1**
(45) Date of publication and mention of the grant of the patent: **21.08.2019**
(21) Application number: 16305431.5
(22) Date of filing: 13.04.2016
(51) Int. Cl.: H01L 41/313, H01L 41/318

(54) **METHOD FOR CHEMICALLY OBTAINING A FLEXIBLE PIEZOELECTRIC STRUCTURE**
VERFAHREN ZUR CHEMISCHEN HERSTELLUNG EINER FLEXIBLEN PIEZOELEKTRISCHEN STRUKTUR
PROCÉDÉ POUR OBTENIR CHIMIQUEMENT UNE STRUCTURE PIÉZO-ÉLECTRIQUE SOUPLE

(43) Date of publication of application: 18.10.2017
(73) Proprietor: CENTRE NATIONAL DE LA RECHERCHE SCIENTIFIQUE, 75794 Paris Cedex 16 (FR); UNIVERSITE DE NANTES, 44035 Nantes Cedex 1 (FR)
(72) Inventor: DUFAY, Thibault, 44230 SAINT SEBASTIEN SUR LOIRE (FR); GINESTAR, Stéphane, 44220 COUERON (FR); SEVENO, Raynald, 44300 NANTES (FR); GUIFFARD, Benoît, 44240 LA CHAPELLE SUR ERDRE (FR)
(74) Representative: Vidon Brevets & Stratégie

(56) References cited:
- JP-A- 2011 071 467
- US-A1- 2013 023 063

## Description

### 1. FIELD OF THE INVENTION

The invention relates to the fabrication of piezoelectric-based composite structures.

More specifically, the invention pertains to a method for obtaining an elastically-flexible piezoelectric structure, commonly referred to as "flexible piezoelectric structure".

Such a flexible piezoelectric structure is a basic structure, mainly comprising a thin layer of piezoelectric material arranged on an elastically-flexible substrate. It is, especially but not exclusively, intended to the realization of energy harvesting devices or systems, such as mechanoelectrical microgenerators for example. Mechanoelectrical microgenerators are usually used to produce electrical energy from ambient mechanical energy.

Throughout this document, "elastically-flexible" means the property according to which a structure or a material presents an elastic behaviour in the sense of physics of materials: the structure or material is deformable when subjected to a deforming mechanical stress and recovers its original shape when this deforming mechanical stress disappears (this is basically referred to as reversible deformation). The terms "elastically-flexible", "elastically deformable" and "flexible" are used interchangeably in this document to refer to an elastic behaviour as described above.

### 2. TECHNOLOGICAL BACKGROUND

Vibration energy harvesting is a booming thematic issue that pushes researchers to develop microgenerators able to supply electronical systems by absorbing ambient mechanical energy present in surrounding environment. Many different mechanical energy ambient sources can be exploited (e.g. energy recovery produced by fluid in movement, by acoustic waves, by mechanical deformations, by work produced by the human body via activities (breathing, walking, etc.), in order to make these devices or systems autonomous.

Recovered energy can be used to supply low-energy electronical devices, like wireless-sensors or electroluminescent diodes for instance.

Piezoelectric materials are promising materials for electromechanical energy conversion technologies. These materials become electrically polarized when subjected to a mechanical stress. In other words, a mechanical stress applied to the piezoelectric material causes an electrical signal by piezoelectric effect. They constitute the active structural layer of the device.

The researchers' efforts in recent years lead to reliable techniques of fabrication of thin-layer structures on flexible support (i.e. on flexible substrate). However the high temperature treatment required for the crystallisation of the piezoelectric material does not allow direct synthesis of the piezoelectric layer on flexible subtract.

A known technique disclosed in « Preparation on transparent flexible piezoelectric energy harvester based on PZT films by laser lift-off process » - Y. H. DO - Sensors and Actuators A - 2013, 200, 51-5*,* relies on a deposition, by a sol-gel process, of a thin layer of Lead Zirconate Titanate (PZT) on a Sapphire substrate. The PZT thin layer is then coated with a polymeric layer (which will act as flexible substrate). A laser lift-off process is then implemented to separate the PZT thin layer and the flexible substrate from the Sapphire substrate: the Sapphire substrate is subjected to ultraviolet laser scanning through the naked face of the substrate (i.e. surface opposed to the deposition surface) and on its overall surface, in order to lift-off the Sapphire substrate and therefore leave the PZT thin layer on the flexible polymeric substrate. The flexible PZT structure thus obtained, a set of electrically conductive electrodes can be then deposited on the PZT thin layer.

However, this fabrication method is based on a process of transfer of the piezoelectric layer on flexible substrate which is complex and costly to implement. On the one hand, it requires using a polished Sapphire substrate, which is a costly material to produce. On the other hand, the laser lift-off process requires using a precise optical system, which is also costly. Finally, because of its complexity, a transfer of this known method to the industrial scale appears difficult. Reference is likewise made to the prior art documents JP2011071467 and US2013023063.

Another drawback is that this method only works with materials compatible with the laser lift-off process, therefore offering a limited choice of possible materials for the fabrication of piezoelectric-based composite structures. The industrial application of such a fabrication method brings up real technological difficulties.

### 3. GOALS OF THE INVENTION

The invention, in at least one embodiment, is aimed especially at overcoming at least some of the cited drawbacks of the prior art.

More specifically, it is a goal of at least one embodiment of the invention to provide a method for fabricating a flexible piezoelectric structure that is simple and low-cost to implement.

It is also an aim of at least one embodiment of the invention to provide a method for large-scale fabrication of a flexible piezoelectric structure (i.e. a method that allows the possibility of industrialized production).

It is another goal of at least one embodiment of the invention to provide a method for fabricating a flexible piezoelectric structure, this method being used to manufacture energy harvesting devices, such as mechanoelectrical microgenerators for example.

### 4. SUMMARY OF THE INVENTION

The invention concerns a method for fabricating an elastically-flexible piezoelectric structure according to the independent method claim 1.

Thus, contrary to the prior art transfer process based on a complex mechanism of separation by laser lift-off, the method according to the invention is based on a wholly chemical process to transfer the piezoelectric material to a flexible polymer substrate. The invention relies on a novel and inventive approach consisting in forming the different structural layers that constitutes the basic piezoelectric structure (permanent substrate included) on a metallic sacrificial substrate, which is then subjected to a chemical etching to remove this sacrificial substrate, to thereby obtain the desired flexible piezoelectric structure. The invention thus offers a simple and low-cost method for forming a basic elastically-flexible piezoelectric structure, which presents real prospects of industrial-scale exploitation. This basic elastically-flexible piezoelectric structure is ready for further depositions or processes for the purpose of integration in energy harvesting devices.

According to a particular feature, the method further comprises a step of depositing an elastically-flexible polymeric adhesion layer on the piezoelectric thin layer before depositing the elastically-flexible polymeric support layer, said elastically-flexible polymeric adhesion and support layers forming the permanent substrate of said structure.

This intermediate adhesion layer, comprised between the piezoelectric layer and the support layer, ensures a good adhesion of the permanent substrate on the piezoelectric thin layer before etching step.

The set of electrically conductive electrodes can comprise, for example, a ground electrode and a signal electrode. After etching the sacrificial substrate, the obtained structure is reversed so that the piezoelectric thin layer is on top of the permanent substrate in order to allow electrode deposition on the revealed face of the piezoelectric thin layer.

According to a particular feature, the set of electrically conductive electrodes is deposited in the form of interdigitated electrodes.

Mechanoelectrical or electromechanical energy conversion is thus improved.

The elastically-flexible coating layer enables to reinforce the elastic behavior of the piezoelectric structure obtained by the method and to hermetically seal the structural layers of the structure. This results in a final flexible piezoelectric structure that can be used as a mechanoelectrical micro-generator.

According to a particular feature, the step of a piezoelectric thin layer is performed by a chemical deposition technique belonging to the group comprising: chemical solution deposition, sol-gel deposition, atmospheric pressure chemical vapor deposition, sputtering deposition.

Sol-gel deposition is the one to be preferred for the method due to its low cost and its simplicity of implementation.

According to a particular feature, the step of depositing an elastically-flexible polymeric support layer is performed using a thermofusing technique.

This technique is simple and low-costly to implement.

According to a particular feature, the step of depositing an elastically-flexible polymeric adhesion layer is performed by a chemical deposition technique belonging to the group comprising: chemical solution deposition, sol-gel deposition.

Sol-gel deposition is the one to be preferred for the method due to its low cost and its simplicity of implementation.

According to a particular feature, the piezoelectric thin layer is made of a piezoelectric material belonging to the group comprising: Lead Zirconate Titanate (PZT), Zinc Oxide (ZnO), Aluminium nitride (AlN), Barium titanate (BaTiO₃), Lithium niobate (LiNbO₃).

Using Lead Zirconate Titanate in particular allows to achieve high energy conversion efficiency.

According to a particular feature, the elastically-flexible polymeric material layer is made of a polymeric material belonging to the group comprising: polyethylene terephthalate (PET), polyurethane (PU), polyimides, polyamides, polyepoxides, polypropylenes, silicones, acrylate polymers, styrenic block elastomers.

Polyethylene terephthalate or polyurethane has elastic and insulating properties particularly well-suited for structures intended to the realization of energy harvesting devices. Its natural flexibility can be changed as a function of the thickness.

According to a particular feature, the adhesion layer is made of a polyurethane-based polymeric material.

According to a particular feature, the elastically-flexible coating layer is made of a polymeric material belonging to the group comprising: polyethylene terephthalate (PET), polyurethane (PU), polyimides, polyamides, polyepoxides, polypropylenes, silicones, acrylate polymers, styrenic block elastomers.

Polyethylene terephthalate or polyurethane has an elastic behaviour particularly well-suited for flexible piezoelectric structures intended to the realization of energy harvesting devices.

According to a particular feature, the metallic sacrificial substrate is made from metallic alloy.

### 5. LIST OF FIGURES

Other features and advantages of embodiments of the invention shall appear from the following description, given by way of an indicative and non-exhaustive examples and from the appended drawings, of which:
- Figure 1 is a flowchart of a particular embodiment of the method according to the invention;
- Figure 2 provides schematic illustrations depicting the different steps of the method described in figure 1;
- Figure 3 provides an example of flexible piezoelectric structure obtained by the method described in figures 1 and 2.

### 6. DETAILED DESCRIPTION

In all of the figures of the present document, identical elements and steps are designated by the same numerical reference sign.

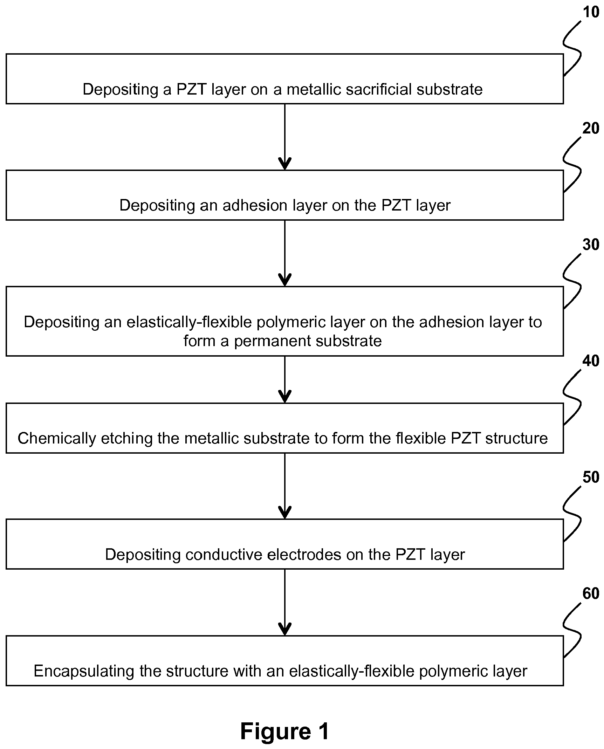

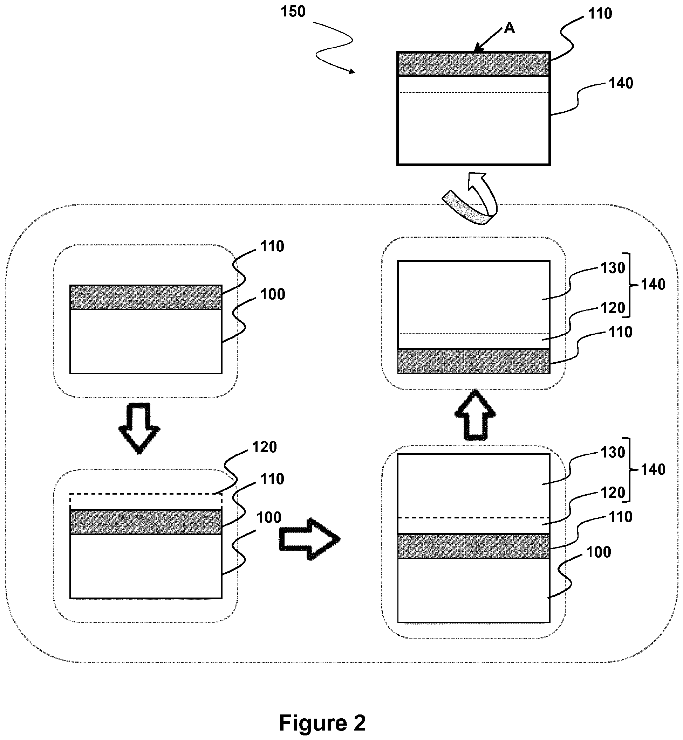

**Figure 1** is a flowchart of a particular embodiment of the method according to the invention. This particular embodiment is also described in relation with **figure 2** which schematically shows the method for fabricating a flexible piezoelectric structure. The following description of this embodiment is an example and is not construed as limiting.

In step 10, a piezoelectric thin layer 110 is deposited on a metallic sacrificial substrate 100, such as Aluminium (Al). Lead Zirconate Titanate (PZT) with formula Pb(Zr_{0,50}, Ti_{0,50})O₃ is the material selected for this piezoelectric thin layer 110 (because of its high ability to convert mechanical energy into electrical energy). This deposition is carried out by means of sol-gel deposition technique. This chemical deposition has several advantages: it is simple to implement, requires low-cost equipment and allows the formation of large-area thin layers of micrometric thickness. It is possible to easily change the composition and thickness of the piezoelectric thin layer. In addition this technique is easily transferable to industrial-scale.

Of course, the PZT thin layer can be formed by other deposition techniques including, but not limited to, chemical solution deposition (CSD), atmospheric pressure chemical vapour deposition (APCVD), sputtering deposition.

For deposition, a precursor solution of PZT is first obtained by mixing the different elementary chemical elements required to make a PZT thin layer. A given quantity of lead acetate is dissolved in a solution of acetic acid. Then a complex of zirconium n-propoxide and a complex of titanium n-propoxide are added to the solution according to the desired proportion (50% Zr and 50% Ti in the present example). Optionally, dopants (such as Lanthanum (La) and/or Strontium (Sr) and/or Barium (Ba)) can also be added to the solution at this step of preparation. Dopant addition enables to change the electrical properties of the PZT thin layer. A given quantity of ethylene glycol is finally added to the solution in order to limit the crack formation within the PZT thin layer during the later thermal treatment. The precursor solution thus obtained is filtered using a particle filter of 0.2 µm in order to obtain a solution perfectly liquid and homogenous (i.e. free of solid particles).

A volume of 24 µl/cm² of the precursor solution is then deposited by spin-coating on a sacrificial substrate which can be chemically etched. The substrate used here is an aluminum thin foil, typically of thickness less than 50 µm, itself placed against a stainless steel plate (of thickness larger than 200 µm) in order to facilitate the spin-coating deposition. The aluminum thin foil has a rectangular deposition surface of several square centimeters. Spin-coating technique allows forming a piezoelectric film on the complete surface of the substrate. The sacrificial substrate rotation speed and spinning duration are chosen according to the desired thickness of thin layer. Typically the rotation speed can be comprised between 2000 and 8500 r.p.m. and the spinning duration can be around twenty-some seconds.

Metallic materials or metallic alloys other than aluminium can be used as temporary sacrificial substrate for the PZT deposition, providing that the chosen material is a chemical etching sensitive material while being chemically and mechanically stable to form a support element allowing later depositions of structural layers.

The aluminium sacrificial substrate on which a PZT precursor solution has been spin-coated is then subjected to a thermal treatment: the set comprising PZT precursor solution on Al substrate is introduced in an oven having a temperature comprised between 550 and 650 °C during a treatment duration from 1 to 3 minutes. This thermal treatment step is used to crystallize the PZT thin layer on the aluminium sacrificial substrate in order to give it its piezoelectric properties.

Tests within the skilled person's scope enables to select the thermal treatment duration and temperature, piezoelectric layer thickness and composition, as a function of the desired elasticity level and crystallization degree inducing exploitable piezoelectric properties.

In practice, the thickness of the PZT thin layer obtained after the execution of step 10 is ranged from 100 to 400 nm. Thus, to form a thicker PZT thin layer, step 10 can be reiterated as many times as necessary to obtain a thin layer of several micrometers.

Because of its ability to achieve high energy conversion efficiency, using a PZT layer is particularly interesting as active material, but other materials can be also envisaged such as: Zinc Oxide (ZnO), Aluminium nitride (AIN), Barium titanate (BaTiO₃), Lithium niobate (LiNbO₃).

In step 20, a polymer-based adhesion layer 120 is deposited on the PZT thin layer 110 by spin-coating. Polyurethane (PU) is a suitable polymeric material for use as adhesion layer. It ensures a good binding between the PZT thin layer 110 and the next layer of polymeric material, which are by nature different. In other words, this adhesion layer ensures that the next layer of polymeric material does not detach from the surface of the PZT thin layer and is resilient. In addition, polyurethane has elastic properties required for the fabrication of the flexible piezoelectric structure. Typically the rotation speed can be comprised between 1000 and 8500 r.p.m. and the spinning duration can be around twenty-some seconds to obtain a layer ranged between 0.5 and 3 µm. Once the polyurethane adhesion layer is deposited, the structure may be annealed (thermal treatment) at a temperature typically ranged from 90 to 100°C, for example 95°C, during 3 to 10 minutes, in order to evaporate solvents included in polyurethane layer.

Of course, the adhesion layer 120 can be formed by other chemical solution deposition techniques than sol-gel deposition.

In step 30, an elastic polymeric support layer 130 is then formed on the PU adhesion layer 120 which recovers the PZT thin layer 110. The set comprising the support layer 130 and the adhesion layer 120 will form the permanent substrate (or permanent support) 140 of the final piezoelectric structure (contrary to the sacrificial substrate 100 which is just a temporary substrate which will be removed using a method described in relation with step 40). Polyethylene terephthalate (PET) and polyurethane (PU) are suitable materials for use as support layer for the desired flexible piezoelectric structure. This step 30 is carried out using a thermofusing technique. Thus, for this step of the method, we shall prefer to use a thermoplastic material, such as PET or PU, which are elastically deformable (at operating temperature) and low-cost polymers. A PET layer of thickness typically ranged between 30 and 250 µm and thermo-fused on the surface of the adhesive layer 120, has showed good results in terms of mechanical properties.

One may also envisage using other kinds of polymers having desired insulating and elasticity properties, such as: polyimides, polyamides, polyepoxides, polypropylenes, silicones, acrylate polymers, styrenic block elastomers, or a combination thereof.

The flexible adhesion layer 120 and flexible support layer 130 can be made of the same material (PU for example), but are not limited to that particular example.

More generally, the support layer 130 of thickness comprised between 1 and 1 000 µm may be used in order to modulate the elasticity of the created composite structure.

It should be noted the deposition of an adhesion layer 120 before the support layer 130 may not be required but it is recommended. In case that an elastic polymeric support layer is coated on the PZT layer without intermediate adhesion layer, only this support layer forms the permanent substrate of the structure.

In step 40, the structure comprising the layers 100 (aluminium sacrificial substrate), 110 (PZT active layer), 120 (PU adhesion layer) and 130 (PET support layer) is immersed in a ferric chloride solution (of formula FeCl₃) to undergo a selective and chemical etching. Indeed, this step aims at selectively etching the aluminium sacrificial substrate 100 which has been used as support for depositions described in steps 10, 20 and 30. A concentration of ferric chloride comprised between 10 and 100% can be used as a function of the desired etching speed, which is function of the thickness of the metallic layer and the nature of the metal used.

In a general manner, the chemical etching must be selective, that is the etching solution must be chosen to only attack the metallic sacrificial substrate 100 while leaving the other layers 110, 120, 130 of the structure intact. In other words, the etching solution must be chemically active in presence of metallic material (e.g. ferric chloride solution for aluminium) and chemically inactive in presence of piezoelectric and polymeric materials (e.g. PZT, PU and PET). The skilled person is able to select other materials and adapt the chemical etching solution in order to meet the above-discussed conditions.

The sacrificial substrate 100 being dissolved, a basic flexible piezoelectric structure 150 is obtained, comprising a crystalline piezoelectric thin layer 110 arranged on a stack of elastically deformable polymeric layers 120, 130 which can be used as the flexible permanent substrate 140 of the structure. The basic structure 150 is free of ground plane and wholly elastically flexible.

The polymeric layer stack 140 has the function of reinforcing the elastic behaviour of the final piezoelectric structure and forms the new material support (substrate) to further depositions.

The method according to the invention therefore makes possible a transfer of the piezoelectric thin layer on a flexible substrate only using a chemical way.

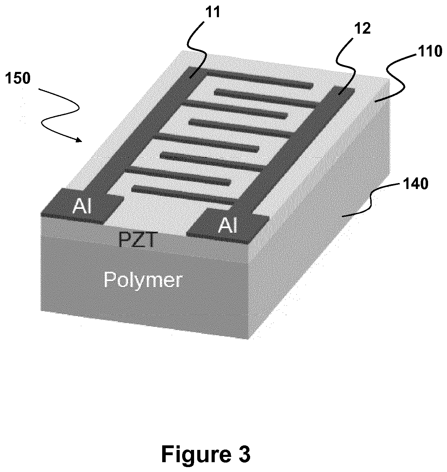

In step 50, a set of interdigitated conductive electrodes 11, 12 can be then attached for example on the face of the PZT layer 110 thus revealed after chemical etching (shown by the arrow A). This can be done by reversing the basic structure 150 so that the piezoelectric thin layer 110 is on top of the permanent substrate 140 and by using one of the following classic deposition techniques: vacuum evaporation deposition or sputtering deposition or electrolyse deposition. A simple deposition of conductive electrodes of aluminium (or other metallic materials like gold or silver) is for instance compatible with the method according to the invention. An example of flexible piezoelectric structure obtained after this step 50 is illustrated on **figure 3**.

In step 60, the flexible piezoelectric structure endowed with interdigitated electrodes can be then encapsulated in an elastic coating layer (not shown on figure 3). The result is a final flexible piezoelectric structure equipped with electrodes that can be used as a mechanoelectrical micro-generator.

Polyethylene terephthalate (PET) is the material selected here for the elastic coating layer mainly due to its mechanical properties.

By encapsulation it means the action of enveloping the basic piezoelectric structure obtained from previous step 50 as a whole with an adapted coating layer. This encapsulation is performed using thermofusing techniques well known of the skilled person. This coating layer has several functions: it forms a protective cover hermetically sealing the structural layers of the piezoelectric structure and reinforces the elasticity of the piezoelectric structure obtained by the method, which will make the micro-generator much more sensitive to ambient mechanical vibrations. The global energy efficiency of the micro-generator is therefore improved.

A PET coating layer of thickness ranged from between 1 to 1 000 µm may be used to achieve the desired effects.

To carry out this encapsulation step, suitable materials for the coating layer comprise, but are not limited to, polyethylene terephthalate (PET), polyurethane (PU) polyimides, polyamides, polyepoxides, polypropylenes, silicones, acrylate polymers, styrenic block elastomers. These low-cost materials belong to the family of thermoplastic polymers which can be easily thermofused. They also make the final piezoelectric structure relatively rigid while having a good long-term elasticity.

Of course these are illustrative examples of materials and other materials, or combination thereof, performing the functions and/or obtaining the same results described herein can be used without departing from the scope of the invention.

Tests within the skilled person's scope enables to select, based on the foregoing description of the invention presented by way of examples only, appropriate materials and dimensions, as a function desired elasticity level and crystallization degree inducing exploitable piezoelectric properties.

Although the present disclosure has been described with reference to one or more examples, workers skilled in the art will recognize that changes may be made in form and detail without departing from the scope of the disclosure and/or the appended claims.

## Claims

1. Method for fabricating an elastically-flexible piezoelectric structure, **characterized in that** it comprises the sequential steps of:
- depositing (10) a piezoelectric thin layer (110) on a metallic sacrificial substrate (100);
- depositing (30) an elastically-flexible polymeric support layer (130) on the piezoelectric thin layer,
- selectively and chemically etching (40) the metallic sacrificial substrate to obtain an elastically-flexible piezoelectric structure comprising the piezoelectric thin layer and the support layer, said support layer being used as permanent substrate (140) of said structure;
- depositing (50) a set of electrically conductive electrodes (11, 12) on a revealed face of the piezoelectric thin layer;
- encapsulating (60) the elastically-flexible piezoelectric structure including said set of electrically conductive electrodes, with an elastically-flexible polymeric coating layer.

2. Method according to claim 1, further comprising a step of depositing (20) an elastically-flexible polymeric adhesion layer (120) on the piezoelectric thin layer before depositing the elastically-flexible polymeric support layer (130), said elastically-flexible polymeric adhesion and support layers forming the permanent substrate (140) of said structure.

3. Method according to any one of claims 1 and 2, wherein the set of electrically conductive electrodes is deposited in the form of interdigitated electrodes.

4. Method according to any one of claims 1 to 3, wherein the step of depositing (10) a piezoelectric thin layer is performed by a chemical deposition technique belonging to the group comprising: chemical solution deposition, sol-gel deposition, atmospheric pressure chemical vapour deposition, sputtering deposition.

5. Method according to any one of claims 1 to 4, wherein the step of depositing (30) an elastically-flexible polymeric support layer is performed using a thermofusing technique.

6. Method according to any one of claims 2 to 5, wherein the step of depositing (20) an elastically-flexible polymeric adhesion layer is performed by a chemical deposition technique belonging to the group comprising: chemical solution deposition, sol-gel deposition.

7. Method according to any one of claims 1 to 6, wherein the piezoelectric thin layer is made of a piezoelectric material belonging to the group comprising: Lead Zirconate Titanate (PZT), Zinc Oxide (ZnO), Aluminium Nitride (AIN), Barium Titanate (BaTiO₃), Lithium Niobate (LiNbO₃).

8. Method according to any one of claims 1 to 7, wherein the elastically-flexible polymeric material layer is made of a polymeric material belonging to the group comprising: polyethylene terephthalate (PET), polyurethane (PU), polyimides, polyamides, polyepoxides, polypropylenes, silicones, acrylate polymers, styrenic block elastomers.

9. Method according to any one of claims 2 to 8, wherein the adhesion layer is made of a polyurethane-based polymeric material.

10. Method according to any one of claims 1 to 9, wherein the elastically-flexible coating layer is made of a polymeric material belonging to the group comprising: polyethylene terephthalate (PET), polyurethane (PU), polyimides, polyamides, polyepoxides, polypropylenes, silicones, acrylate polymers, styrenic block elastomers.

11. Method according to any one of claims 1 to 10, wherein the metallic sacrificial substrate is made from a metallic alloy.

## Patentansprüche

1. Verfahren zum Herstellen einer elastisch-flexiblen piezoelektrischen Struktur, **dadurch gekennzeichnet, dass** es die aufeinanderfolgenden Schritte
- Abscheiden (10) einer piezoelektrischen dünnen Schicht (110) auf einem metallischen Opfersubstrat (100);
- Abscheiden (30) einer elastisch-flexiblen polymeren Trägerschicht (130) auf der piezoelektrischen dünnen Schicht,
- selektives und chemisches Ätzen (40) des metallischen Opfersubstrates um eine elastisch-flexible piezoelektrische Struktur zu erhalten, die die piezoelektrische dünne Schicht und die Trägerschicht umfasst, wobei die Trägerschicht als dauerhaftes Substrat (140) der Struktur verwendet wird;
- Abscheiden (50) eines Satzes elektrisch leitfähiger Elektroden (11, 12) auf einer enthüllten Oberfläche der piezoelektrischen dünnen Schicht;
- Ummanteln (60) der elastisch-flexiblen piezoelektrischen Struktur einschließlich des Satzes elektrisch leitfähiger Elektroden mit einer elastisch-flexiblen polymeren Überzugsschicht
umfasst.

2. Verfahren nach Anspruch 1, weiterhin umfassend einen Schritt des Abscheidens (20) einer elastisch-flexiblen polymeren Adhäsionsschicht (120) auf der piezoelektrischen dünnen Schicht vor dem Abscheiden der elastisch-flexiblen polymeren Trägerschicht (130), wobei die elastisch-flexiblen polymeren Adhäsions- und Trägerschichten das dauerhafte Substrat (140) der Struktur bilden.

3. Verfahren nach einem der Ansprüche 1 und 2, wobei der Satz elektrisch leitfähiger Elektroden in Form von interdigitalen Elektroden abgeschieden wird.

4. Verfahren nach einem der Ansprüche 1 bis 3, wobei der Schritt des Abscheidens (10) einer piezoelektrischen dünnen Schicht durch eine chemische Abscheidungstechnik ausgeführt wird, die zu der Gruppe gehört, welche chemische Lösungsabscheidung, Sol-Gel-Abscheidung, chemische Gasphasenabscheidung bei Atmosphärendruck und Sputter-Abscheidung umfasst.

5. Verfahren nach einem der Ansprüche 1 bis 4, wobei der Schritt des Abscheidens (30) einer elastisch-flexiblen polymeren Trägerschicht unter Anwendung einer Wärmeschmelztechnik ausgeführt wird.

6. Verfahren nach einem der Ansprüche 2 bis 5, wobei der Schritt des Abscheidens (20) einer elastisch-flexiblen polymeren Adhäsionsschicht durch eine chemische Abscheidungstechnik ausgeführt wird, die zu der Gruppe gehört, welche chemische Lösungsabscheidung und Sol-Gel-Abscheidung umfasst.

7. Verfahren nach einem der Ansprüche 1 bis 6, wobei die piezoelektrische dünne Schicht aus einem piezoelektrischen Material gefertigt ist, das zu der Gruppe gehört, die Bleizirkonattitanat (PZT), Zinkoxid (ZnO), Aluminiumnitrid (AIN), Bariumtitanat (BaTiO₃) und Lithiumniobat (LiNbO₃) umfasst.

8. Verfahren nach einem der Ansprüche 1 bis 7, wobei die elastisch-flexible polymere Materialschicht aus einem polymeren Material gefertigt ist, das zu der Gruppe gehört, die Polyethylenterephthalat (PET), Polyurethan (PU), Polyimide, Polyamide, Polyepoxide, Polypropylene, Silikone, Acrylatpolymere und Styrol-Block-Elastomere umfasst.

9. Verfahren nach einem der Ansprüche 2 bis 8, wobei die Adhäsionsschicht aus einem Polyurethan-basierten polymeren Material gefertigt ist.

10. Verfahren nach einem der Ansprüche 1 bis 9, wobei die elastisch-flexible Überzugsschicht aus einem polymeren Material gefertigt ist, das zu der Gruppe gehört, die Polyethylenterephthalat (PET), Polyurethan (PU), Polyimide, Polyamide, Polyepoxide, Polypropylene, Silikone, Acrylatpolymere und Styrol-Block-Elastomere umfasst.

11. Verfahren nach einem der Ansprüche 1 bis 10, wobei das metallische Opfersubstrat aus einer metallischen Legierung gefertigt ist.

## Revendications

1. Procédé pour fabriquer une structure piézoélectrique élastiquement flexible, **caractérisé en ce qu'**il comprend les étapes séquentielles suivantes :
- le dépôt (10) d'une couche mince piézoélectrique (110) sur un substrat métallique sacrificiel (100) ;
- le dépôt (30) d'une couche de support polymère élastiquement flexible (130) sur la couche mince piézoélectrique,
- la gravure sélective et chimique (40) du substrat métallique sacrificiel pour obtenir une structure piézoélectrique élastiquement flexible comprenant la couche mince piézoélectrique et la couche de support, ladite couche de support étant utilisée comme substrat permanent (140) de ladite structure ;
- le dépôt (50) d'un ensemble d'électrodes électroconductrices (11, 12) sur une face révélée de la couche mince piézoélectrique ;
- l'encapsulation (60) de la structure piézoélectrique élastiquement flexible incluant ledit ensemble d'électrodes électroconductrices, avec une couche de revêtement polymère élastiquement flexible.

2. Procédé selon la revendication 1, comprenant en outre une étape de dépôt (20) d'une couche d'adhérence polymère élastiquement flexible (120) sur la couche mince piézoélectrique avant le dépôt de la couche de support polymère élastiquement flexible (130), lesdites couches de support et d'adhérence polymères élastiquement flexibles formant le substrat permanent (140) de ladite structure.

3. Procédé selon l'une quelconque des revendications 1 et 2, dans lequel l'ensemble d'électrodes électroconductrices est déposé sous la forme d'électrodes interdigitées.

4. Procédé selon l'une quelconque des revendications 1 à 3, dans lequel l'étape de dépôt (10) d'une couche mince piézoélectrique est effectuée par une technique de dépôt chimique appartenant au groupe comprenant : un dépôt chimique par solution, un dépôt par sol-gel, un dépôt chimique en phase vapeur sous pression atmosphérique, un dépôt par pulvérisation cathodique.

5. Procédé selon l'une quelconque des revendications 1 à 4, dans lequel l'étape de dépôt (30) d'une couche de support polymère élastiquement flexible est effectuée en utilisant une technique de thermofusion.

6. Procédé selon l'une quelconque des revendications 2 à 5, dans lequel l'étape de dépôt (20) d'une couche d'adhérence polymère élastiquement flexible est effectuée par une technique de dépôt chimique appartenant au groupe comprenant : un dépôt chimique par solution, un dépôt par sol-gel.

7. Procédé selon l'une quelconque des revendications 1 à 6, dans lequel la couche mince piézoélectrique est faite d'un matériau piézoélectrique appartenant au groupe comprenant : le titano-zirconate de plomb (PZT), l'oxyde de zinc (ZnO), le nitrure d'aluminium (AlN), le titanate de baryum (BaTiO₃), le niobate de lithium (LiNbO₃).

8. Procédé selon l'une quelconque des revendications 1 à 7, dans lequel la couche de matériau polymère élastiquement flexible est faite d'un matériau polymère appartenant au groupe comprenant : un polytéréphtalate d'éthylène (PET), un polyuréthane (PU), les polyimides, les polyamides, les polyépoxydes, les polypropylènes, les silicones, les polymères d'acrylate, les élastomères styréniques séquencés.

9. Procédé selon l'une quelconque des revendications 2 à 8, dans lequel la couche d'adhérence est faite d'un matériau polymère à base de polyuréthane.

10. Procédé selon l'une quelconque des revendications 1 à 9, dans lequel la couche de revêtement élastiquement flexible est faite d'un matériau polymère appartenant au groupe comprenant : un polytéréphtalate d'éthylène (PET), un polyuréthane (PU), les polyimides, les polyamides, les polyépoxydes, les polypropylènes, les silicones, les polymères d'acrylate, les élastomères styréniques séquencés.

11. Procédé selon l'une quelconque des revendications 1 à 10, dans lequel le substrat métallique sacrificiel est fait d'un alliage métallique.
